# FASCICULE DE BREVET EUROPEEN

(11) **EP 0 669 572 B1**
(45) Date de publication et mention de la délivrance du brevet: **23.04.1997**
(21) Numéro de dépôt: 95400366.1
(22) Date de dépôt: 21.02.1995
(51) Int. Cl.: G06F 7/48, H03K 17/687, H03K 17/693

(54) **Etage de formatage d'opérandes optimisé**
Optimierte Operandformatierungsstufe
Optimised operand formatting stage

(30) Priorité: 28.02.1994 FR 9402283
(43) Date de publication de la demande: 30.08.1995
(73) Titulaire: SGS-THOMSON MICROELECTRONICS S.A., 94250 Gentilly (FR)
(72) Inventeur: Curtet, Joel, F-75116 Paris (FR); Tsang, Fangwo, F-75116 Paris (FR)
(74) Mandataire: Schmit, Christian Norbert Marie

(56) Documents cités:
- EP-A- 0 343 968
- DE-A- 3 709 675
- US-A- 4 157 589
- IEICE TRANSACTIONS ON ELECTRONICS, vol. E75-C,no. 4, Avril 1992 TOKYO JP, pages 371-382, XP 000301666 A. CHANDRAKASAN ET AL. 'Low-Power CMOS Digital Design'
- N. WESTE ET AL. 'PRINCIPLES OF CMOS VLSI DESIGN, A Systems Perspective' 1985 , ADDISON WESLEY , READING, US. paragraphe 1.4, pages 8-18 * page 14, ligne 17 - ligne 20; figure 1.8D *

## Description

### Domaine technique

La présente invention concerne un étage de formatage d'opérandes numériques et plus spécifiquement, un circuit de formatage d'opérandes numériques C-MOS optimisé pour la gestion du format des données numériques présentées aux entrées d'un additionneur complet. Un tel étage est par exemple décrit dans le document US-A-4 157 589, en technologie bipolaire.

### Arrière-plan technologique

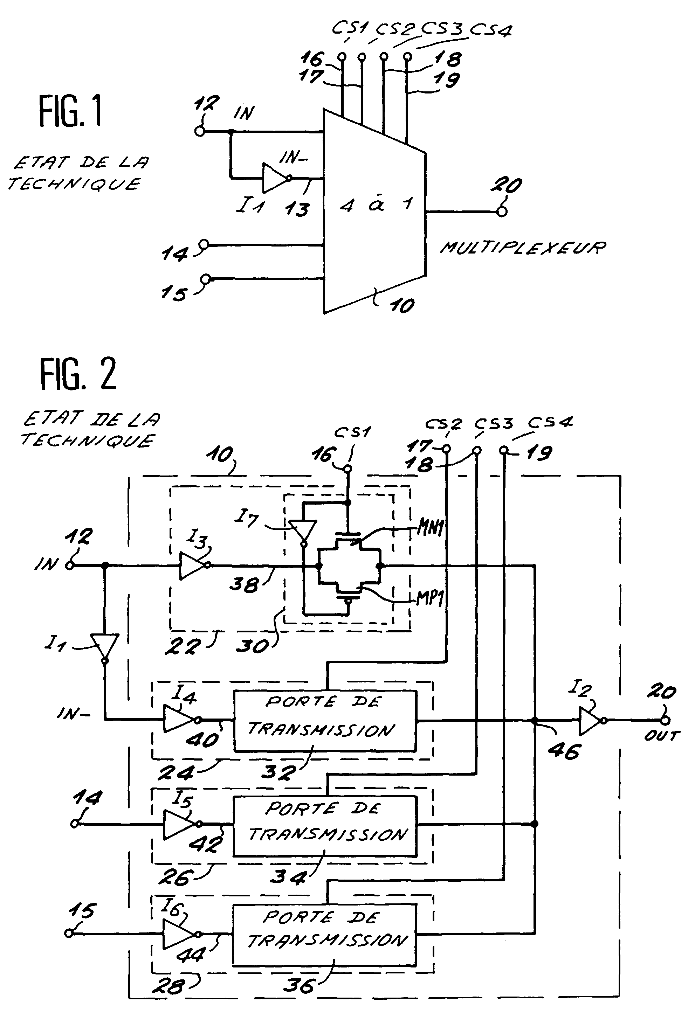

La Figure 1 est un schéma fonctionnel d'une réalisation d'un étage de formatage d'opérandes numériques connu, qui est en fait un multiplexeur 4-à-1 (10); un tel multiplexeur 10 trouve une application dans les unités logiques et arithmétiques (ULA), où un multiplexeur 10 est utilisé pour formater un opérande numérique d'entrée d'une ULA avant l'addition.

En se référant à la Figure 1, le multiplexeur 10 possède quatre bornes d'entrée de données, de 12 à 15 incluse, quatre bornes de commande de commutation des entrées, de 16 à 19 incluse, et une borne de sortie des données 20.

La borne 12 véhicule un signal d'entrée de données IN qui représente un signal d'entrée de données binaires, alors que la borne 13 véhicule le signal d'entrée de données IN- inverse au signal d'entrée de données IN de la borne 12. Le signal d'entrée de données IN- de la borne 13 peut être aisément généré en connectant les bornes respectives d'entrée et de sortie d'un inverseur I1 aux bornes 12 et 13, respectivement, du multiplexeur 10, comme illustré.

La borne 14 véhicule un signal d'entrée de données 0 à état logique fixe. La borne 15 véhicule un signal d'entrée de données 1 à état logique fixe. Les bornes 14 et 15 ont toujours des signaux d'entrée de données dont l'état logique est fixe et complémentaire.

Les bornes 16, 17 18 et 19 véhiculent les signaux respectifs de commande de commutation des données CS1, CS2, CS3 et CS4 inclus. Les signaux de commande de commutation CS1 à CS4 inclus sont conçus et gérés de telle sorte que l'un des signaux présents sur les bornes 12 à 15 incluse apparaît à la borne de sortie des données 20.

La borne de sortie des données 20 véhicule un signal de sortie des données OUT qui représente l'un des quatre signaux d'entrée des données IN, IN-, 0 ou 1 véhiculés respectivement par les bornes 12, 13, 14 et 15. Le signal de sortie des données OUT peut avoir le même état logique que l'un quelconque des signaux d'entrée de données, soit IN, IN-, 0 et 1, selon les états logiques des signaux de commande de commutation des entrées CS1 à CS4 inclus.

La Figure 2 constitue un schéma de connexion plus détaillé d'une réalisation du multiplexeur 10.

En se référant à la Figure 2, le multiplexeur 10 comprend quatre portes de transmission tamponnées 22, 24, 26 et 28 et un tampon d'inversion des sorties I2.

Chacune des portes de transmission tamponnées 22, 24, 26 et 28 comprend un tampon d'inversion des entrées, respectivement I3, I4, I5 et I6, et une porte de transmission, respectivement 30, 32, 34 et 36.

Les bornes d'entrée correspondantes 12, 13, 14 et 15 de l'inverseur I1 et les tampons d'inversion 12, 13 et 14 véhiculent respectivement les signaux d'entrée des données IN, IN-, 0 et 1.

Chacune des portes de transmission 30, 32, 34, et 36 comprend un transistor à canal N MN1, un transistor à canal P MP1 et un inverseur 17.

Les bornes de gâchette des transistors MN1 et MP1 sont reliées respectivement aux bornes d'entrée et de sortie de l'inverseur 17.

Les bornes de gâchette des transistors MN1; dans les portes de transmission 30, 32, 34, et 36, représentent respectivement les bornes de commande de commutation des entrées 16, 17, 18 et 19.

Les bornes de source respectives des transistors MN1 et MP1, dans chacune des portes de transmission 30, 32, 34 et 36, sont reliées les unes aux autres et connectées respectivement aux bornes de sortie 38, 40, 42 et 44 des tampons d'inversion I3, I4, I5 et I6, respectivement.

Les bornes de drain respectives des transistors MN1 et MP1, dans les portes de transmission 30, 32, 34, et 36, sont reliées les unes aux autres et connectées respectivement à la borne d'entrée 46 du tampon d'inversion des sorties I2.

La borne de sortie 20 du tampon d'inversion 12 véhicule le signal de sortie OUT.

Les inverseurs I1 à I7 inclus sont fonctionnellement connectés à un rail d'alimentation en tension positive et négative, VDD et VSS respectivement (non illustré).

Concernant le fonctionnement du circuit illustré dans la Figure 2; seul l'un des signaux de commande de commutation des entrées CS1 à CS4 inclus, aura un état logique haut, c'est-à-dire 1, à un moment quelconque, c'est pourquoi une seule des portes de transmission 30, 32, 34 ou 36 sera capable de transmettre un signal.

Par exemple, en supposant que le signal de commande de commutation des entrées CS1 à la borne 16 se trouve dans l'état logique haut, les signaux de commande des entrées CS2, CS3 et CS4 se trouveront dans l'état logique bas, seul le transistor MN1 passera le signal de l'entrée 38 vers la sortie 46 de la porte de transmission 30 lorsque l'état logique du signal à l'entrée 38 du commutateur de données est dans l'état logique bas, c'est-à-dire l'état logique 0. Cependant, si l'état logique du signal à l'entrée 38 de la porte de transmission 30 est dans l'état logique haut, c'est-à-dire l'état logique 1, c'est le transistor MP1 qui passera le signal de l'entrée 38 vers la sortie 46 de la porte de transmission 30. Par conséquent, le signal OUT à la borne 20 aura le même état logique que le signal IN à la borne 12, quel que soit son état. Le même principe opérationnel s'applique aux portes de transmission 32, 34 et 36.

La Figure 2 illustre seulement l'une des différentes réalisations possibles d'un circuit qui permet de formater un opérande numérique. L'inconvénient associé au circuit de la Figure 2, et à d'autres réalisations, est que sa mise en application nécessite un nombre considérable de transistors. Si la Figure 2 est supposée être mise en application selon une technologie C-MOS et utilisée en conjonction avec une ULA 16 bits, 896 transistors seraient alors nécessaires pour le formatage de tous les opérandes numériques que reçoit l'ULA. Il est bien connu que la fiabilité d'un système diminue, et que le temps et l'effort nécessaires à sa conception augmentent en proportion directe du nombre de transistors employés. Il est bien connu que plus il y a de transistors dans un système, plus l'espace nécessaire et la consommation de courant augmentent, plus sa fiabilité dimininue et plus il requiert d'efforts et de temps pour sa conception.

### OBJECTIF ET RESUME DE L'INVENTION

Le but de la présente invention est de permettre d'optimiser la conception d'un circuit de formatage d'opérandes numériques, en particulier mais non exclusivement en vue de son utilisation avec un additionneur complet, ayant un nombre réduit de transistors par rapport aux circuits de formatage d'opérandes numériques actuels, réduisant ainsi la taille, la consommation de courant, l'effort et le temps de conception globaux d'un système, et améliorant ainsi la fiabilité générale du système.

Cet objectif est atteint par la création d'un chemin général comprenant un inverseur connecté en parallèle à deux inverseurs reliés en série et en établissant des portes entre les trois inverseurs selon l'opérande à déterminer.

Cet objectif est accompli selon la présente invention telle qu'elle est définie dans la revendication 1, entre autre au moyen d'un étage de formatage d'opérandes numériques qui comprend un premier moyen d'inversion ayant une borne d'alimentation, une borne de masse, une entrée et une sortie; d'un second moyen d'inversion ayant une borne d'alimentation, une borne de masse, une entrée qui est reliée à l'entrée dudit premier moyen d'inversion et une sortie; d'un troisième moyen d'inversion ayant une borne d'alimentation, une borne de masse, une entrée qui est reliée à la sortie dudit second moyen d'inversion et une sortie qui est reliée à la sortie dudit premier moyen d'inversion; et, d'un moyen général de commutation pour la commutation dudit premier moyen d'inversion et/ou dudit second moyen d'inversion et/ou dudit troisième moyen d'inversion.

L'objet de la présente invention est encore accompli en ce que ledit moyen général de commutation comprend: un premier moyen de commutation commandé par un premier signal de commande pour l'établissement d'une connexion électrique entre une tension d'alimentation positive et ladite borne d'alimentation dudit premier moyen d'inversion; un deuxième moyen de commutation commandé par un second signal de commande pour l'établissement d'une connexion électrique entre une tension d'alimentation négative et ladite borne de masse dudit premier moyen d'inversion; un troisième moyen d'inversion commandé par ledit second signal de commande pour l'établissement d'une connexion électrique entre ladite tension d'alimentation positive et ladite borne d'alimentation dudit troisième moyen d'inversion; un quatrième moyen de commutation commandé par ledit premier signal de commande pour l'établissement d'une connexion électrique entre ladite tension d'alimentation négative et ladite borne de masse dudit troisième moyen d'inversion. En outre, lesdits premier, deuxième, troisième et quatrième moyens de commutation sont commandés par un signal de commande commun; l'un au moins desdits moyens d'inversion comprend un inverseur C-MOS connu; lesdits premier et troisième moyens de commutation comprennent chacun au moins un transistor à canal P; lesdits deuxième et quatrième moyens de commutation comprennent chacun au moins un transistor à canal N; lesdits premier, deuxième et troisième moyens d'inversion comprennent chacun un inverseur C-MOS connu;

L'objet est en outre accompli selon la présente invention en ce que: deux étages de formatage d'opérandes numériques sont commandés indépendamment de sorte que lesdits étages de formatage d'opérandes numériques se combinent pour former un ensemble de formatage d'opérandes numériques; les signaux de sortie dudit ensemble de formatage d'opérandes numériques sont reliés aux entrées d'un additionneur complet connu de telle façon que ledit ensemble de formatage d'opérandes numériques et ledit additionneur complet se combinent pour former un additionneur formaté d'opérandes numériques; une pluralité desdits additionneurs formatés d'opérandes numériques sont commandés en parallèle.

### BREVE DESCRIPTION DES DESSINS

Une réalisation d'un circuit selon la présente invention est décrite en détail ci-dessous en se référant aux plans, parmi lesquels:
La Figure 1 illustre un multiplexeur 4-à-1 déjà décrit;
La Figure 2 illustre un schéma de connexion plus détaillé de la Figure 1;
La Figure 3 illustre un schéma fonctionnel d'une réalisation préférée de l'invention;
La Figure 4 illustre un schéma de connexion détaillé de la Figure 3;
La Figure 5 illustre un schéma fonctionnel d'une autre réalisation de l'invention;
La Figure 6 illustre un schéma fonctionnel d'un ensemble de formatage d'opérandes numériques;
La Figure 7 illustre un schéma fonctionnel d'un ensemble de formatage d'opérandes numériques relié à un additionneur complet; et,
La Figure 8 illustre un schéma fonctionnel d'une pluralité d'additionneurs de formatage d'opérandes.

### DESCRIPTION DETAILLEE DE LA REALISATION PREFEREE

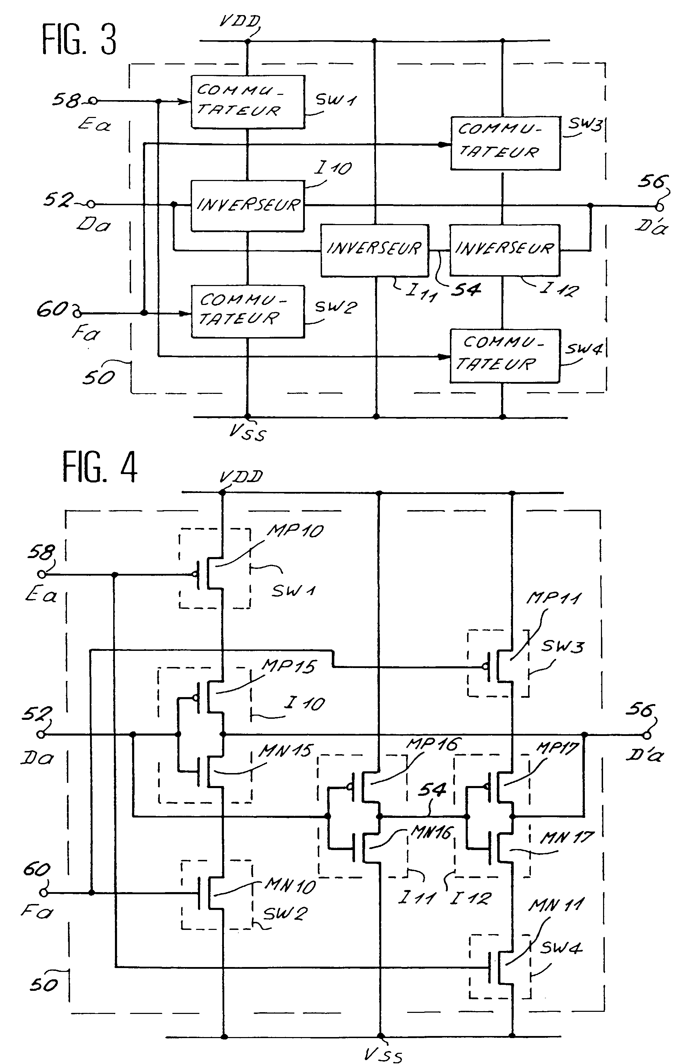

La Figure 3 illustre un schéma fonctionnel d'une réalisation préférée de l'invention.

En se référant à la Figure 3, l'étage de formatage d'opérandes numériques optimisé 50 comprend un moyen général de commutation et trois moyens d'inversion, I10 à I12 inclus. Le moyen général de commutation comprend quatre moyens de commutation, SW1 à SW4 inclus, chacun ayant trois bornes. Les inverseurs I10 à I12 inclus ont chacun quatre bornes.

Les premières bornes respectives des commutateurs SW1 et SW3 sont reliées au rail d'alimentation en tension positive VDD.

Les bornes respectives du côté haut, c'est-à-dire du côté alimentation, des inverseurs I10 et I12 sont reliées aux deuxièmes bornes respectives des commutateurs SW1 et SW3.

Les premières bornes respectives des commutateurs SW2 et SW4 sont reliées aux bornes respectives du côté bas, c'est-à-dire du côté masse, des inverseurs I10 et I12.

Les deuxièmes bornes respectives des commutateurs SW2 et SW4 sont reliées au rail d'alimentation en tension négative VSS.

Les bornes respectives des côtés haut et bas de l'inverseur I11 sont reliées aux rails d'alimentation en tension positive et négative, respectivement VDD et VSS.

La borne d'entrée 52 de l'étage de formatage d'opérandes numériques 50 est reliée aux bornes d'entrée des inverseurs I10 et I11 et véhicule le signal d'entrée des données Da.

La borne d'entrée 54 de l'inverseur I12 est reliée à la borne de sortie de l'inverseur I11.

Les bornes de sortie des inverseurs I10 et I12 sont reliées l'une à l'autre et forment la borne de sortie 56 de l'étage de formatage d'opérandes numériques 50, qui véhicule le signal de sortie des données Da'....

L'étage de formatage d'opérandes possède deux bornes de commande de commutation des entrées 58, 60, qui véhiculent les signaux de commande de commutation Ea et Fa.

Les commutateurs SW1 et SW4 sont tous deux commandés, via leurs troisièmes bornes respectives, par le signal de commande de commutation Ea et les commutateurs SW2 et SW3 sont commandés, via leurs troisièmes bornes respectives, par le signal de commande de commutation Fa.

La Figure 4 illustre un schéma de connexion détaillé de la Figure 3.

En se référant à la Figure 4, les commutateurs SW1 et SW3 sont mis en application en utilisant des transistors MOS à canal P, respectivement MP10 et MP11. Les bornes de source des transistors MP10 et MP11 sont reliées au rail d'alimentation en tension négative VDD, alors que leurs bornes de drain respectives sont reliées aux côtés bas des inverseurs I10 et I12, respectivement.

Les commutateurs SW2 et SW4 sont mis en application en utilisant des transistors MOS à canal N, respectivement MN10 et MN11. Les bornes de source des transistors MN10 et MN11 sont reliées au rail d'alimentation en tension négative VSS, alors que leurs bornes de drain respectives sont reliées aux côtés hauts respectifs des inverseurs I10 et 12.

Les bornes de gâchette 58 des transistors MP10 et MN11 sont commandées par le signal de commande de commutation Ea, alors que les bornes de gâchette 60 des transistors MP11 et MN10 sont commandées par le signal de commande de commutation Fa.

Les inverseurs I10 à I12 inclus sont chacun mis en application par un inverseur C-MOS connu reliés d'une manière opérationnelle connue.

L'inverseur I10 comprend un transistor à canal P MP15 et un transistor à canal N MN15.

L'inverseur I11 comprend un transistor à canal P MP16 et un transistor à canal N MN16.

L'inverseur I12 comprend un transistor à canal P MP17 et un transistor à canal N MN17.

Le Tableau 1 est une table de vérité du fonctionnement du circuit illustré dans la Figure 4, dans laquelle X désigne l'état indifférent.

**TABLEAU 1**

| Da | Ea | Fa | Da' |
|---|---|---|---|
| X | 0 | 0 | 1 |
| 0 | 0 | 1 | 1 |
| 1 | 0 | 1 | 0 |
| 0 | 1 | 0 | 0 |
| 1 | 1 | 0 | 1 |
| X | 1 | 1 | 0 |

Se référer à la Figure 4.

Lorsque les signaux de commande de commutation Ea et Fa se trouvent tous deux dans l'état logique 0, le signal de sortie des données Da' se trouve toujours dans l'état logique 1, quel que soit l'état logique du signal d'entrée des données Da, la raison étant que:
l'inverseur I10 ne peut fournir du courant à sa borne de sortie 56 que lorsque sa borne d'entrée 52 se trouve dans l'état logique 0, et ne peut recevoir du courant depuis sa sortie 56 lorsque son entrée se trouve dans l'état logique 1; et
l'inverseur I12 ne peut fournir du courant à sa borne de sortie 56 que lorsque sa borne d'entrée 52 se trouve dans l'état logique 0, et ne peut recevoir du courant depuis sa sortie 56 lorsque son entrée se trouve dans l'état logique 1, puisque;
les transistors MP10 et MP11 sont mis à 1 et que les transistors MN10 et MN11 sont mis à 0.

Par conséquent: lorsque le signal d'entrée des données Da, à la borne 52, se trouve dans l'état logique 0, la borne 54 se trouve dans l'état logique 1, et le signal de sortie des données Da' passe à l'état logique 1, c'est-à-dire environ VDD, via les transistors MP10 et MP15; lorsque le signal d'entrée des données Da, à la borne 52, se trouve dans l'état logique 1, la borne 54 se trouve dans l'état logique 0, et le signal de sortie des données Da' passe à l'état logique 1 via les transistors MP11 et MP17.

Lorsque les signaux de commande de commutation Ea et Fa se trouvent tous deux dans l'état logique 1, le signal de sortie des données Da' se trouve toujours dans l'état logique 0, quel que soit l'état logique du signal d'entrée des données Da, la raison étant que:
l'inverseur I10 ne peut recevoir du courant depuis sa borne de sortie 56 que lorsque sa borne d'entrée 52 se trouve dans l'état logique 1, et ne peut fournir du courant à sa sortie 56 lorsque son entrée 52 se trouve dans l'état logique 0; et
l'inverseur I12 ne peut recevoir du courant depuis sa borne de sortie 56 que lorsque sa borne d'entrée 54 se trouve dans l'état logique 1, et ne peut fournir du courant à sa sortie 56 lorsque son entrée 54 se trouve dans un état logique 0, puisque;
les transistors MP10 et MP11 sont mis à 0 et que les transistors MN10 et MN11 sont mis à 1.

Par conséquent: lorsque le signal d'entrée des données Da, à la borne 52, se trouve dans l'état logique 1, la borne 54 se trouve dans l'état logique 0, et le signal de sortie des données Da' passe à l'état logique 0, c'est-à-dire environ VSS, via les transistors MN10 et MN15; lorsque le signal d'entrée des données Da, à la borne 52, se trouve dans l'état logique 0, la borne 54 se trouve dans l'état logique 1, et le signal de sortie des données Da' passe à l'état logique 0 via les transistors MN11 et MN17.

Lorsque le signal de commande de commutation Ea se trouve dans l'état logique 1 et que le signal de commande de commutation Fa se trouve dans l'état logique 0, les signaux d'entrée et de sortie des données, respectivement Da et Da', de l'étage de formatage d'opérandes numériques 50, sont toujours dans le même état logique, quel que soit l'état logique du signal d'entrée des données Da, la raison étant que:
l'inverseur I10 ne peut ni fournir ni recevoir du courant à ou depuis sa borne de sortie 56, quel que soit l'état logique de sa borne d'entrée 52; et
l'inverseur I12 peut soit fournir, soit recevoir du courant à ou depuis sa borne de sortie 56 selon l'état logique de sa borne d'entrée 54; puisque;
les transistors MP10 et MN10 sont mis à 0 et que les transistors MP11 et MN11 sont mis à 1.

Par conséquent: lorsque le signal d'entrée des données Da, à la borne 52, se trouve dans l'état logique 0, la borne 54 se trouve dans l'état logique 1, et le signal de sortie des données Da' passe à l'état logique 0 via les transistors MN11 et MN17; lorsque le signal d'entrée des données Da, à la borne 52, se trouve dans l'état logique 1, la borne 54 se trouve dans l'état logique 0, et le signal de sortie des données Da' passe à l'état logique 1 via les transistors MP11 et MP17.

Lorsque le signal de commande de commutation Ea se trouve dans l'état logique 0 et que le signal de commande de la commutation Fa se trouve dans l'état logique 1, les signaux d'entrée et de sortie des données, respectivement Da et Da', de l'étage de formatage d'opérandes 50, se trouvent toujours dans des états logiques opposés, quel que soit l'état logique du signal d'entrée Da, la raison étant que:
l'inverseur I10 peut soit fournir, soit recevoir du courant à ou depuis sa borne de sortie 56 selon l'état logique de sa borne d'entrée 52; et
l'inverseur I12 ne peut ni fournir ni recevoir du courant à ou depuis sa borne de sortie 56, quel que soit l'état logique de sa borne d'entrée 54; puisque;
les transistors MP10 et MN10 sont mis à 1 et que les transistors MP11 et MN11 sont mis à 0.

Par conséquent: lorsque le signal d'entrée des données Da, à la borne 52, se trouve dans l'état logique 0, la borne 54 se trouve dans l'état logique 1, et le signal de sortie des données Da' passe à l'état logique 1 via les transistors MP10 et MP15; lorsque le signal d'entrée des données Da, à la borne 52, se trouve dans l'état logique 1, la borne 54 se trouve dans l'état logique 0, et le signal de sortie des données Da' passe à l'état logique 0 via les transistors MN10 et MN15.

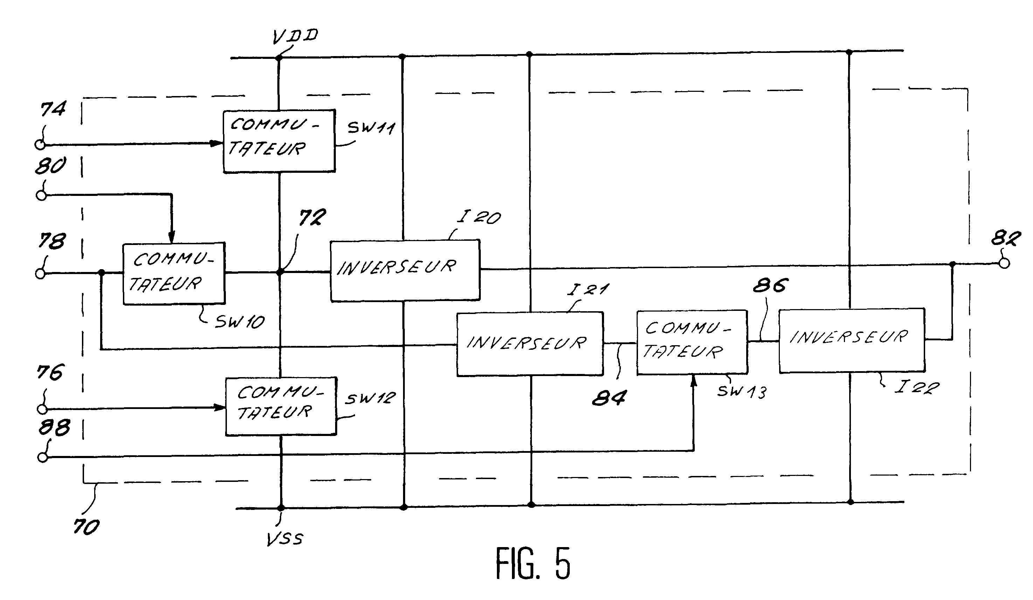

La Figure 5 est un schéma fonctionnel d'une autre réalisation de l'invention.

En se référant à la Figure 5, l'étage de formatage d'opérandes numériques 70 comprend un moyen général de commutation et trois moyens d'inversion, I20 à I22 inclus. Le moyen général de commutation comprend quatre moyens de commutation, SW10 à SW13 inclus, chacun ayant trois bornes. Les inverseurs I20 à I22 inclus ont chacun quatre bornes.

La première borne du commutateur SW11 est reliée au rail d'alimentation en tension positive VDD, alors que sa deuxième borne 72 est reliée à la première borne du commutateur SW12, dont la deuxième borne est reliée au rail d'alimentation en tension négative VSS. Les troisièmes bornes respectives 74, 76 des commutateurs SW11 et SW12 véhiculent leurs signaux de commande de commutation respectifs.

La première borne du commutateur SW10 constitue la borne d'entrée des données 78 de l'étage de formatage d'opérandes numériques 70. La deuxième borne du commutateur SW10 est reliée à la deuxième et à la première borne des commutateurs SW11 et SW12, respectivement. La troisième borne 80 du commutateur SW10 véhicule le signal de commande de commutation.

Les bornes respectives du côté haut des inverseurs I20 à I22 inclus sont reliées au rail d'alimentation en tension positive VDD, alors que leurs bornes respectives du côté bas sont reliées au rail d'alimentation en tension négative VSS.

La borne 72 des commutateurs SW10 à SW12 inclus sont reliées à la borne d'entrée de l'inverseur I20, dont la borne de sortie constitue la borne de sortie des données 82 de l'étage de formatage d'opérandes numériques 70.

La borne d'entrée de l'inverseur I21 est reliée à la borne d'entrée des données 78 de l'étage de formatage d'opérandes numériques 70.

La première borne du commutateur SW13 est reliée à la borne de sortie 84 de l'inverseur I21.

La borne d'entrée de l'inverseur I22 est reliée à la deuxième borne 86 du commutateur SW13.

La troisième borne 88 du commutateur SW13 véhicule son signal de commande de commutation.

La borne de sortie de l'inverseur I22 est reliée à la borne de sortie 82 de l'étage de formatage d'opérandes numériques 70, c'est-à-dire à la sortie de l'inverseur I20.

Dans le circuit de formatage d'opérandes 70 de la Figure 5, tous les inverseurs et tous les commutateurs, à l'exception des commutateurs SW10 et SW13, peuvent être mis en application comme illustré dans la Figure 4. Les commutateurs SW10 et SW13 doivent être réalisés en utilisant une structure (30) de type porte de transmission qui est identique, ou identique du point de vue opérationnel, à celle de la Figure 2.

La commande des commutateurs SW10 à SW13 inclus doit être telle que la Table de vérité du Tableau 1 soit satisfaite.

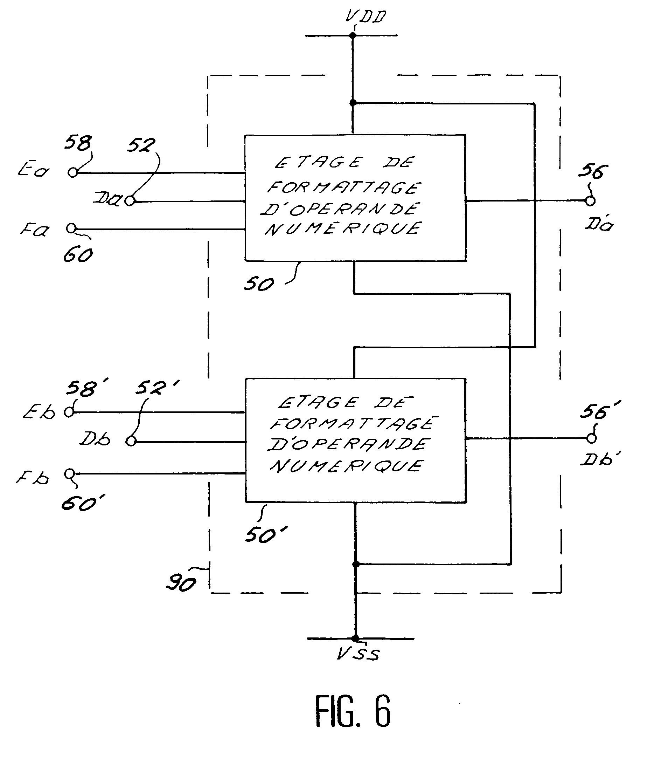

La Figure 6 illustre un schéma fonctionnel de deux étages de formatage d'opérandes numériques 50, 50', du type montré dans la Figure 4, qui fonctionnent indépendamment. La combinaison des deux étages de formatage d'opérandes numériques 50, 50' sera ici désignée comme l'ensemble de formatage d'opérandes numériques 90. Il faut noter, afin d'éviter toute confusion, que les bornes et les signaux d'entrée et les bornes et les signaux de sortie des étages de formatage d'opérandes 50, 50' diffèrent par leurs suffixes, soit Db, Db', Eb, Fb, 52', 56', 58' et 60'.

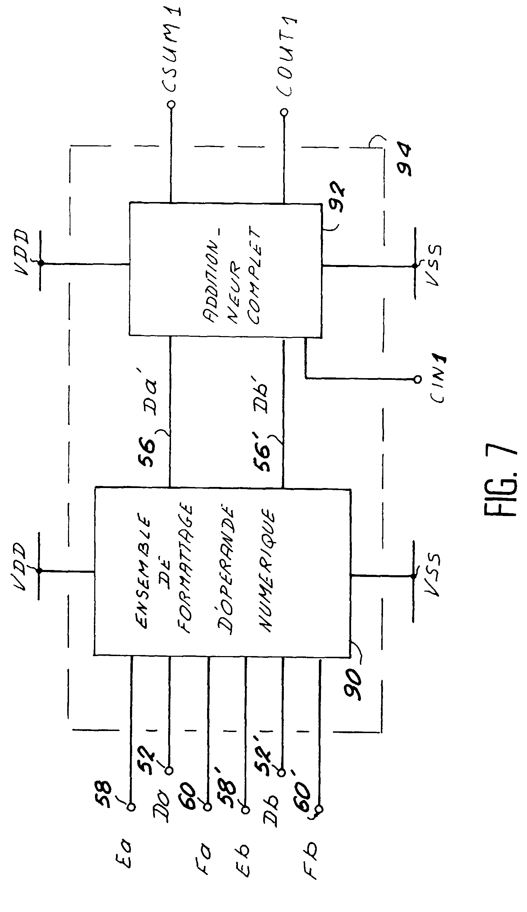

La Figure 7 est un schéma fonctionnel d'un ensemble de formatage d'opérandes numériques relié à un additionneur complet connu 92.

En se référant à la Figure 7, les sorties respectives 56, 56' de l'ensemble de formatage d'opérandes numériques 90 sont reliées aux entrées de l'additionneur complet 92, qui possède une entrée supplémentaire CIN et deux sorties SUM et COUT, et est fonctionnellement relié aux rails d'alimentation en tension positive et négative, respectivement VDD et VSS. La combinaison de l'ensemble de formatage d'opérandes numériques 90 et de l'additionneur complet 92 sera ici dénommée additionneur formaté d'opérandes numériques 94.

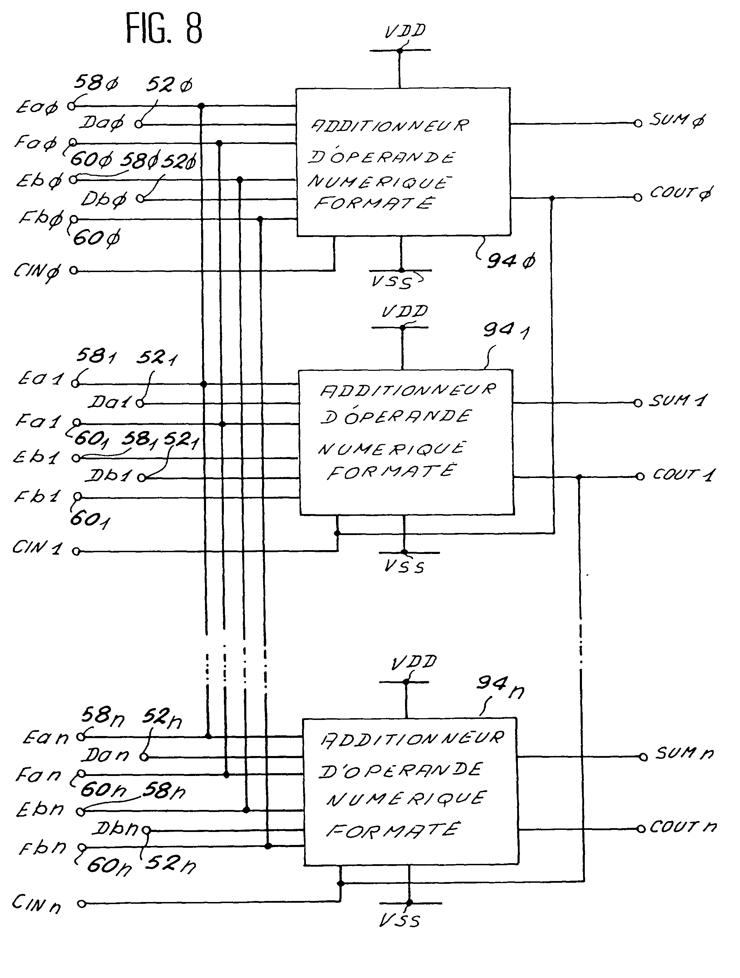

La Figure 8 est un schéma fonctionnel d'une pluralité d'additionneurs formatés d'opérandes numériques 94.

En se référant à la Figure 8, il faut noter qu'on ajoute un suffixe supplémentaire à chacune des entrées et des sorties des n+l additionneurs formatés d'opérandes numériques, en commençant par zéro (0) et en terminant par un nombre indéfini n; lorsque n est un nombre entier supérieur à 1, le suffixe a été inclus. Les signaux de commande de commutation des entrées respectifs Eax, Fax, Ebx et Fbx, où x désigne chacun des nombres entiers de zéro à n, sont tous respectivement reliés et donc commandés ensemble. Notez également que les sorties respectives COUTx de chacun des additionneurs formatés d'opérandes numériques 94x sont reliées aux entrées respectives CINx + 1 de chaque additionneur formaté d'opérandes numériques 94x successif.

En formatant les entrées de données Dax et Dbx des additionneurs formatés d'opérandes numériques 94x, au moyen des signaux de commande Ea, Fa, Eb et Fb, il est possible de faire réaliser par tous les additionneurs complets, outre l'opération normale d'addition, des opérations de soustraction, de soustraction inverse, d'égalisation de Dax ou d'égalisation de Dbx, d'inversion de Dax ou d'inversion de Dbx, d'incrémentation de Dax ou d'incrémentation de Dbx, de décrémentation de Dax ou de décrémentation de Dbx.

L'essence de l'invention devrait maintenant apparaître clairement et, en fait, le nombre de transistors, d'après le circuit de la Figure 4, nécessaire pour formater les données d'entrée vers une ULA 16 bits est de 320. Par conséquent, une économie considérable (896 - 320 = 576) est réalisée au niveau du nombre de transistors requis, sans parler du gain de place ou de la consommation d'énergie. De plus, le schéma de connexion de la Figure 4 se prête à la création d'une cellule nette et compacte pour la planification d'un CI comprenant une ULA multibit, par exemple.

## Revendications

1. Etage de formatage d'opérandes numériques (50) caractérisé en ce qu'il comprend:
- un premier, un deuxième, et un troisième inverseur commandé (I10, I11, I12), ayant chacun respectivement une borne d'alimentation, une borne de masse, une entrée (52) et une sortie (56);
- le deuxième inverseur (I11) ayant son entrée reliée à l'entrée (52) du premier inverseur (I10);
- le troisième inverseur (I12) ayant son entrée reliée à la sortie (54) du deuxième inverseur (I11) et sa sortie reliée à la sortie (56) du premier inverseur (I10);
- l'entrée et la sortie de l'étage étant constituées par respectivement l'entrée et la sortie du premier inverseur;
- un moyen général de commutation de l'alimentation électrique comprenant des moyens de commutation (SW1-SW4) couplés aux inverseurs pour la commutation dudit premier inverseur (I10) ou dudit deuxième inverseur, (I11) et dudit troisième inverseur (I12) selon l'opérande numérique à déterminer en sortie.

2. Etage de formatage selon la revendication 1, caractérisé en ce que le moyen général de commutation comporte
- un premier commutateur (SW1) commandé par un premier signal de commande (Ea) afin d'établir une connexion électrique entre une tension d'alimentation positive (VDD) et ladite borne d'alimentation dudit premier inverseur (I10);
- un second commutateur (SW2) commandé par un second signal de commande (Fa) afin d'établir une connexion électrique entre une tension d'alimentation négative (VSS) et ladite borne de masse dudit premier inverseur (I10);
- un troisième commutateur (SW3) commandé par ledit second signal de commande (Fa) afin d'établir une connexion électrique entre ladite tension d'alimentation positive (VDD) et ladite borne d'alimentation dudit troisième inverseur (I12);
- un quatrième commutateur (SW4) commandé par ledit premier signal de commande (Ea) afin d'établir une connexion électrique entre ladite tension d'alimentation négative (VSS) et ladite borne de masse dudit troisième inverseur (I12);

3. Etage de formatage selon la Revendication 2 caractérisé en ce que lesdits premier, deuxième, troisième et quatrième commutateurs (SW1, SW2, SW3, SW4) sont commandés par un signal de commande commun.

4. Etage de formatage selon les Revendications 1, 2 et 3 caractérisé en ce que l'un au moins desdits inverseurs (I10, I11, I12) comprend un inverseur C-MOS connu.

5. Etage de formatage selon les Revendications 1, 2 et 3 caractérisé en ce que lesdits premier et troisième commutateurs (SW1, SW3) comprennent chacun au moins un transistor à canal P (MP10, MP11).

6. Etage de formatage selon les Revendications 1, 2 et 3 caractérisé en ce que lesdits deuxième et quatrième commutateurs (SW2, SW4) comprennent chacun au moins un transistor à canal N (MN10, MN11).

7. Etage de formatage selon les Revendications 1, 2 et 3 caractérisé en ce que:
- ledit premier inverseur (I10) comprend un inverseur C-MOS connu;
- ledit deuxième inverseur (I11) comprend un inverseur C-MOS connu:
- ledit troisième inverseur (I12) comprend un inverseur C-MOS connu:
- ledit premier commutateur (SW1) comprend au moins un transistor à canal P (MP10);
- ledit deuxième commutateur (SW2) comprend au moins un transistor à canal N (MN10);
- ledit troisième commutateur (SW3) comprend au moins un transistor à canal P (MP11); et
- ledit quatrième commutateur (SW4) comprend au moins un transistor à canal N (MN11).

8. Ensemble de formatage d'opérandes numériques (90) caractérisé en ce qu'il comporte deux étages de formatage d'opérandes numériques (50,50') selon les revendications 1 à 7 incluses et en ce que ces étages sont commandés indépendamment.

9. Ensemble de formatage selon la Revendication 8 caractérisé en ce que ses signaux de sortie (Da', Db') sont reliés aux entrées du cumulateur et du cumulande d'un additionneur complet connu (92), de façon à ce que ledit ensemble de formatage d'opérandes numériques (90) et ledit additionneur complet (92) se combinent pour former un additionneur formaté d'opérandes numériques (94).

10. Ensemble de formatage selon la Revendication 9 caractérisée en ce qu'il est commandé en parallèle avec un autre ensemble de formatage du même type.

## Patentansprüche

1. Stufe zur Formatierung numerischer Operanden (50),
dadurch gekennzeichnet, daß sie umfaßt:
einen ersten, einen zweiten und einen dritten gesteuerten Inverter (I10, I11, I12), die jeweils einen Versorgungsanschluß, einen Massenanschluß, einen Eingang (52) und einen Ausgang (56) aufweisen;
wobei der Eingang des zweiten Inverters (I11) mit dem Eingang (52) des ersten Inverters (I10) verbunden ist;
wobei der Eingang des dritten Inverters (I12) mit dem Ausgang (54) des zweiten Inverters (I11) und sein Ausgang mit dem Ausgang (56) des ersten Inverters (I10) verbunden ist;
wobei Eingang und Ausgang der Stufe gebildet werden durch jeweils den Eingang und den Ausgang des ersten Inverters;
eine allgemeine Vorrichtung zum Umschalten der elektrischen Versorgung, die Vorrichtungen zum Umschalten des ersten Inverters (I10) oder des zweiten Inverters (I11) und des dritten Inverters (I12) entsprechend dem am Ausgang zu bestimmenden numerischen Operator umfaßt.

2. Stufe zur Formatierung nach Anspruch 1,
dadurch gekennzeichnet, daß die allgemeine Umschaltvorrichtung umfaßt:
einen ersten Schalter (SW1), der durch ein erstes Steuersignal (Ea) gesteuert wird, so daß eine elektrische Verbindung zwischen einer positiven Versorgungsspannung (VDD) und dem Versorgungsanschluß des ersten Inverters (I10) hergestellt wird;
einen zweiten Schalter (SW2), der durch ein zweites Steuersignal (Fa) gesteuert wird, so daß eine elektrische Verbindung zwischen einer negativen Versorgungsspannung (VSS) und dem Masseanschluß des ersten Inverters (I10) hergestellt wird;
einen dritten Schalter (SW3), der durch das zweite Steuersignal (Fa) angesteuert wird, so daß eine elektrische Verbindung zwischen der positiven Versorgungsspannung (VDD) und dem Versorgungsanschluß des dritten Inverters (I12) hergestellt wird;
einen vierten Schalter (SW4), der durch das erste Steuersignal (Ea) angesteuert wird, so daß eine elektrische Verbindung zwischen der negativen Versorgungsspannung (VSS) und dem Masseanschluß des dritten Inverters (I12) hergestellt wird.

3. Stufe zur Formatierung nach Anspruch 2,
dadurch gekennzeichnet, daß
der erste, zweite, dritte und vierte Schalter (SW1, SW2, SW3, SW4) durch ein gemeinsames Steuersignal angesteuert wird.

4. Stufe zur Formatierung nach den Ansprüchen 1, 2 und 3,
dadurch gekennzeichnet, daß
wenigstens einer der Inverter (I10, I11, I12) einen bekannten C-MOS-Inverter umfaßt.

5. Stufe zur Formatierung nach den Ansprüchen 1, 2 und 3,
dadurch gekennzeichnet, daß
der erste und dritte Schalter (SW1, SW3) jeweils wenigstens einen P-Kanal-Transistor (MP10, MP11) umfaßt.

6. Stufe zur Formatierung nach den Ansprüchen 1, 2 und 3,
dadurch gekennzeichnet, daß
der zweite und vierte Schalter (SW2, SW4) jeweils wenigstens einen N-Kanal-Transistor (MN10, MN11) umfaßt.

7. Stufe zur Formatierung nach den Ansprüchen 1, 2 und 3,
dadurch gekennzeichnet, daß
der erste Inverter (I10) einen bekannten C-MOS-Inverter umfaßt;
der zweite Inverter (I11) einen bekannten C-MOS-Inverter umfaßt;
der dritte Inverter (I12) einen bekannten C-MOS-Inverter umfaßt;
der erste Schalter (SW1) wenigstens einen P-Kanal-Transistor (MP10) umfaßt;
der zweite Schalter (SW2) wenigstens einen N-Kanal-Transistor (MN10) umfaßt;
der dritte Schalter (SW3) wenigstens einen P-Kanal-Transistor (MP11) umfaßt; und
der vierte Schalter (SW4) wenigstens einen N-Kanal-Transistor (MN11) umfaßt.

8. Anordnung zur Formatierung von numerischen Operanden (90),
dadurch gekennzeichnet, daß
sie zwei Stufen zur Formatierung numerischer Operanden (50, 50') gemäß den Ansprüchen 1 bis 7 einschließlich umfaßt und dadurch daß diese Stufen unabhängig ansteuerbar sind.

9. Anordnung zur Formatierung nach Anspruch 8,
dadurch gekennzeichnet, daß
ihre Ausgangssignale (Da', Db') an den Eingängen eines bekannten Volladdierers (92) für Addenden und Summanden anliegen, so daß sich die Anordnung zur Formatierung numerischer Operanden (90) und Volladdierer (92) zu einem formatierten Addierer für numerische Operanden (94) zusammenfügt.

10. Anordnung zur Formatierung nach Anspruch 9,
dadurch gekennzeichnet, daß
sie parallel zu einer anderen Anordnung zur Formatierung desselben Typs angesteuert wird.

## Claims

1. Stage for formatting digital operands (50), characterised in that it comprises:
- a first, a second and a third controlled inverter (I10, I11, I12) each having respectively a supply terminal, an earth terminal, an input (52) and an output (56);
- the second inverter (I11) having its input connected to the input (52) of the first inverter (I10);
- the third inverter (I12) having its input connected to the output (54) of the second inverter (I11) and its output connected to the output (56) of the first inverter (I10);
- the input and the output of the stage consisting respectively of the input and output of the first inverter;
- a general switching means for the electrical supply comprising means for the switching of the said first inverter (I10) or of the said second inverter (I11) and of the said third inverter (I12) depending on the digital operand to be determined at the output.

2. Formatting stage according to Claim 1, characterised in that the general switching means includes
- a first switch (SW1) controlled by a first control signal (Ea) so as to establish an electrical connection between a positive supply voltage (VDD) and the said supply terminal of the said first inverter (I10);
- a second switch (SW2) controlled by a second control signal (Fa) so as to establish an electrical connection between a negative supply voltage (VSS) and the said earth terminal of the said first inverter (I10);
- a third switch (SW3) controlled by the said second control signal (Fa) so as to establish an electrical connection between the said positive supply voltage (VDD) and the said supply terminal of the said third inverter (I12);
- a fourth switch (SW4) controlled by the said first control signal (Ea) so as to establish an electrical connection between the said negative supply voltage (VSS) and the said earth terminal of the said third inverter (I12);

3. Formatting stage according to Claim 2, characterised in that the said first, second, third and fourth switches (SW1, SW2, SW3, SW4) are controlled by a common control signal.

4. Formatting stage according to Claims 1, 2 and 3, characterised in that at least one of the said inverters (I10, I11, I12) comprises a known CMOS inverter.

5. Formatting stage according to Claims 1, 2 and 3, characterised in that the said first and third switches (SW1, SW3) each comprise at least one p-channel transistor (MP10, MP11).

6. Formatting stage according to Claims 1, 2 and 3, characterised in that the said second and fourth switches (SW2, SW4) each comprise at least one n-channel transistor (MN10, MN11).

7. Formatting stage according to Claims 1, 2 and 3, characterised in that:
- the said first inverter (I10) comprises a known CMOS inverter;
- the said second inverter (I11) comprises a known CMOS inverter;
- the said third inverter (I12) comprises a known CMOS inverter;
- the said first switch (SW1) comprises at least one p-channel transistor (MP10);
- the said second switch (SW2) comprises at least one n-channel transistor (MN10);
- the said third switch (SW3) comprises at least one p-channel transistor (MP11); and
- the said fourth switch (SW4) comprises at least one n-channel transistor (MN11).

8. Assembly for formatting digital operands (90) characterised in that it includes two stages for formatting digital operands (50, 50') according to Claims 1 to 7 inclusive and in that these stages are controlled independently.

9. Formatting assembly according to Claim 8, characterised in that its output signals (Da', Db') are connected to the addend and augend inputs of a known full adder (92), so that the said assembly for formatting digital operands (90) and the said full adder (92) are combined to form a formatted adder of digital operands (94).

10. Formatting assembly according to Claim 9, characterised in that it is controlled in parallel with another formatting assembly of the same type.
